# EUROPEAN PATENT APPLICATION

(11) **EP 4 808 284 A1**
(43) Date of publication of application: **16.09.2026**
(21) Application number: 24888366.2
(22) Date of filing: 30.08.2024
(51) Int. Cl.: H05K 1/02, H01L 23/12, H05K 1/09, H05K 3/32

(54) **CIRCUIT BOARD AND MANUFACTURING METHOD THEREFOR**

(30) Priority: 10.11.2023 JP 2023192068
(71) Applicant: NHK Spring Co., Ltd., Yokohama-shi, Kanagawa 236-0004 (JP)
(72) Inventor: TANAKA, Ryo, Yokohama-shi Kanagawa 236-0004 (JP)
(74) Representative: Oppermann, Frank
(86) International application number: PCT/JP2024/031386
(87) International publication number: WO 2025/100064

(57) **Abstract**

Provided is a circuit board capable of suppressing damage to an insulating layer due to heat input to an additional metal layer. The circuit board is provided with a circuit pattern 3 provided on an insulating substrate 5, 7, an additional metal layer 9 stacked and bonded on the circuit pattern 3 for connecting another member 11 using welding, wherein the additional metal layer 9 is provided with a bonding surface 10 bonded to the circuit pattern 3, the bonding surface 10 includes a bonded portion 10a bonded to the circuit pattern 3 in a range facing the circuit pattern 3 in the stacking direction and an un-bonded portion 10b other than the bonded portion 10a, and a total thickness of the additional metal layer 9 and the circuit pattern 3 in the stacking direction is 1.2 mm to 3.0 mm.

## Description

### FIELD OF THE INVENTION

The present invention relates to a circuit board used for a power device or the like, and a manufacturing method for the same.

### BACKGROUND OF THE INVENTION

As a circuit board for large current used in a power device or the like, there is one that reduces thermal resistance by partially increasing a thickness of a circuit pattern. For example, Patent Literature 1 discloses a structure in which a thickness of a circuit pattern is increased in a portion where an electronic component such as a semiconductor chip is attached.

Namely, the circuit board of Patent Literature 1 is configured by providing an insulating layer containing inorganic fillers on a base metal and laminating a circuit pattern thereon. On the circuit pattern, a stacked circuit pattern is stacked as an additional metal layer by a cold spraying method, and the circuit pattern is increased in thickness by the stacked circuit pattern.

In this circuit board, if an electronic component is mounted on the stacked circuit pattern, heat of the electronic component is diffused in the thick portion of the circuit pattern. Thermal resistance is, therefore, reduced, to configure the circuit board superior in heat dissipation with less thermal resistance.

If the heat input to the stacked circuit pattern increases, the heat is, however, transmitted to the insulating layer through the circuit pattern and the insulating layer may be damaged. Although this may be dealt with by thickening the stacked circuit pattern, there is a problem that increase in size is caused.

### CITATION LIST

### PATENT LITERATURE

PATENT LITERATURE 1: JP2006-319146A

### SUMMARY OF THE INVENTION

### PROBLEMS TO BE SOLVED BY THE INVENTION

The problem to be solved is that there is a risk to damage an insulating layer as heat input to an additional metal layer increases.

### MEANS FOR SOLVING THE PROBLEM

The present invention provides a circuit board comprising a circuit pattern provided on an insulating layer, and an additional metal layer stacked and bonded on the circuit pattern for connecting another member, wherein the additional metal layer comprises a bonding surface with respect to the circuit pattern, and a connecting surface positioned on a side opposite to the bonding surface in a stacking direction for connecting the other member, wherein the bonding surface includes a bonded portion bonded to the circuit pattern in a range facing the circuit pattern in the stacking direction and an un-bonded portion other than the bonded portion, and a total thickness of the additional metal layer and the circuit pattern in the stacking direction is 1.2 mm to 3.0 mm.

The present invention also provide a manufacturing method for a circuit board stacking the additional metal layer on the circuit pattern, and pressing a tool partially against the connecting surface of the additional metal layer and ultrasonically vibrating the tool, to bond part of the bonding surface onto the circuit pattern, the part corresponding to, in the stacking direction, a portion on the connecting surface of the additional metal layer pressed with the tool .

### EFFECT OF THE INVENTION

The present invention suppresses damage to an insulating layer due to heat input to an additional metal layer.

### BRIEF DESCRIPTION OF THE DRAWINGS

[FIG. 1] FIG. 1 is a sectional view of a circuit board illustrating an attaching portion of another member and a periphery thereof according to an embodiment 1 of the present invention.
[FIG. 2] FIG. 2 is a plan view of the circuit board of FIG. 1.
[FIG. 3] FIGS. 3(A) and 3(B) illustrate an additional metal layer of the circuit board of FIG. 1, in which FIG. 3(A) is a plan view and FIG. 3 (B) is a bottom view.
[FIG. 4] FIG. 4 is a sectional view illustrating an experimental method according to the embodiment 1.
[FIG. 5] FIG. 5 is a graph plotting experimental results of FIG. 4.
[FIG. 6] FIG. 6 is a schematic sectional view of a situation in which the additional metal layer is ultrasonically bonded to a circuit pattern.
[FIG. 7] FIG. 7 is an enlarged sectional view of a portion of a tool of FIG. 6 pressed against the additional metal layer.
[FIG. 8] FIG. 8 is a sectional view illustrating an attaching portion of another member and a periphery thereof according to an embodiment 2 of the present invention.
[FIG. 9] FIG. 9 is a sectional view of a circuit board illustrating an attaching portion of another member and a periphery thereof according to an embodiment 3 of the present invention.
[FIG. 10] FIG. 10 is a plan view of the circuit board of FIG. 9.

### EMBODIMENT FOR CARRYING OUT THE INVENTION

The object of suppressing damage to an insulating layer due to heat input to an additional metal layer is accomplished by partially bonding an additional metal layer and a circuit pattern at an interface and adjusting a thickness of the additional metal layer and the circuit board.

A circuit board 1 is provided with a circuit pattern 3 and an additional metal layer 9. The circuit pattern 3 is provided on an insulating substrate 5, 7. The additional metal layer 9 is stacked and bonded on the circuit pattern 3 for connecting another member 11.

The additional metal layer 9 is provided with a bonding surface 10 and a connecting surface 12. The bonding surface 10 is a surface bonded to the circuit pattern 3. The connecting surface 12 is a surface located on an opposite side to the bonding surface 10 in the stacking direction for connecting the other member 11.

The bonding surface 10 includes a bonded portion 10a bonded to the circuit pattern 3 in a range facing the circuit pattern 3 in the stacking direction, and an un-bonded portion 10b other than the bonded portion 10a. A total thickness of the additional metal layer 9 and the circuit pattern 3 in the stacking direction is 1.2 mm to 3.0 mm.

The respective thicknesses of the additional metal layer 9 and the circuit pattern 3 may be arbitrarily set as long as a sum thereof is 1.2 mm to 3.0 mm. As one embodiment, the thickness of the additional metal layer 9 in the stacking direction may be 0.4 mm to 2.7 mm, and the thickness of the circuit pattern 3 in the stacking direction may be 0.3 mm to 0.8 mm.

In this way, the thickness of the additional metal layer 9 in the stacking direction may be larger than the thickness of the circuit pattern 3 in the stacking direction.

The additional metal layer 9 may be constant or varied in thickness in the stacking direction. In one embodiment, the thickness at the un-bonded portion 10b of the bonding surface 10 in the stacking direction may be smaller than the thickness at the bonded portion 18a of the bonding surface 10 in the stacking direction.

Shapes of the un-bonded portion 10b and the bonded portion 10a of the bonding surface 10 may be arbitrarily set. As one embodiment, the bonded portion 10a may be formed in a circumferential shape, and the un-bonded portion 10b may be located inside the circumferential shape of the bonded portion 10a.

The additional metal layer 9 may include an uneven portion 17. The uneven portion 17 is provided in at least part of the connecting surface 12 corresponding to the bonded portion 10a of the additional metal layer 9 in the stacking direction. As one embodiment, the uneven portion 17 may be provided in a whole region of the connecting surface 12 of the additional metal layer 9.

The other member 11 connected to the connecting surface 12 of the additional metal layer 9 in the stacking direction may be a conductive plate material having a thickness of 0.2 mm to 1.2 mm in the stacking direction.

The manufacturing method for the circuit board 1, in one embodiment, stacks the additional metal layer 9 on the circuit pattern 3, and presses the tool T partially against the connecting surface 12 of the additional metal layer 9 and ultrasonically vibrating the tool. Thus, part of the bonding surface 10 corresponding to, in the stacking direction, a portion of the connecting surface 12 of the additional metal layer 9 pressed with the tool T is bonded onto the circuit pattern 3.

As another embodiment, the manufacturing method for the circuit board 1 may stack an additional metal layer 9 on the circuit pattern 3, and press the tool T wholly against the connecting surface 12 of the additional metal layer 9 and ultrasonically vibrate the tool. In this case, part of the bonding surface 10 is bonded onto the circuit pattern 3 within a range of the bonding surface 10 corresponding to, in the stacking direction, a portion of the connecting surface 12 of the additional metal layer 9 pressed with the tool T.

The other member 11 may be connected to the connecting surface 12 of the additional metal layer 9 bonded on the circuit pattern 3.

### EMBODIMENT 1

### [Circuit Board]

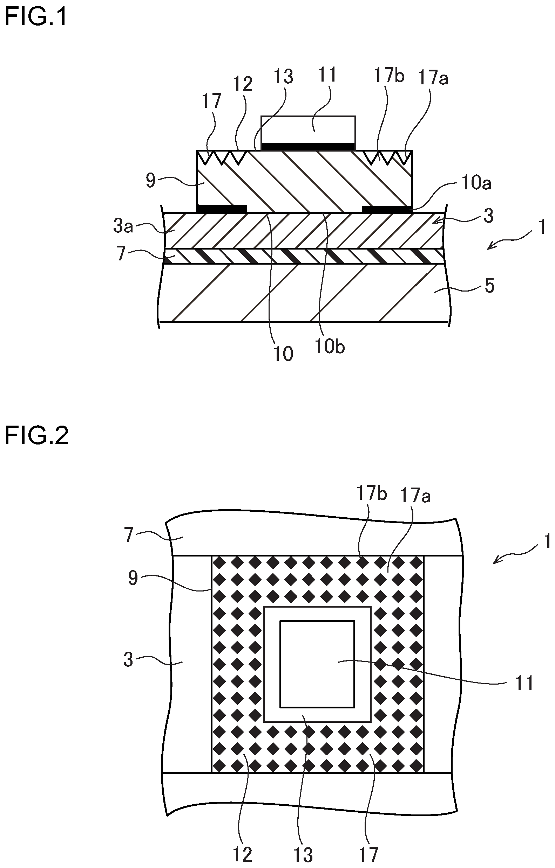

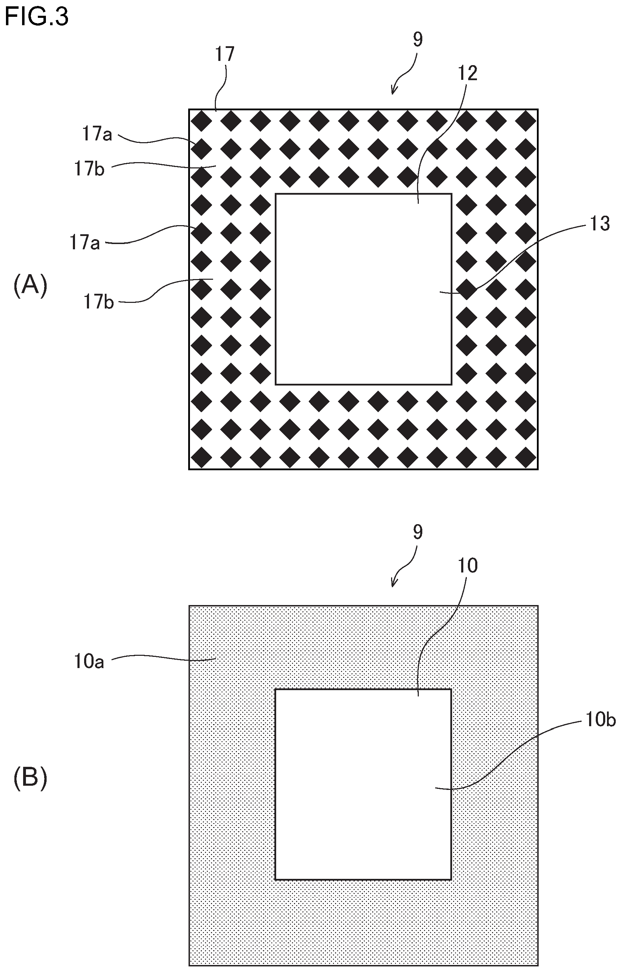

FIG. 1 is a sectional view of a circuit board illustrating an attaching portion of another member and a periphery thereof according to the embodiment 1 of the present invention. FIG. 2 is a plan view of the circuit board of FIG. 1. FIG. 3(A) is a plan view illustrating an additional metal layer of the circuit board of FIG. 1, and FIG. 3(B) is a bottom view of the same.

A circuit board 1 in FIGS. 1 to 3 is a circuit board for large current such as a power device. The circuit board 1 is a metal-based circuit board including a metal substrate 5, an insulating layer 7, and a circuit pattern 3. The circuit board 1, however, does not need to be the metal-based circuit board as long as the circuit board has the insulating layer 7.

The metal substrate 5 is made of a plate-shaped body made of metal. In addition, the shape of the metal substrate 5 may be appropriately set and may adopt a heat sink shape.

Material of the metal substrate 5 may employ, for example, single metal or alloy such as aluminum, iron, copper, or stainless steel, and there is no limitation on the presence or absence of flexibility. The metal substrate 5 may further include a non-metal such as carbon. Further, the metal substrate 5 may contain aluminum composited with carbon. Further, the metal substrate 5 may have a single-layer structure or a multilayer structure.

Although a thickness of the metal substrate 5 may be appropriately set, the thickness of the metal substrate is set to, for example, 2.0mm. The metal substrate 5 has a high thermal conductivity. For example, it has a thermal conductivity of 370-400 W m -1 K -1 in the case of copper material, 190-220 W m -1 K -1 in the case of aluminum material, or 60-80 W m -1 K -1 in the case of iron material.

The insulating layer 7 is laminated on the metal substrate 5 and is formed in a plate shape. The insulating layer 7 functions to electrically insulate the circuit pattern 3 from the metal substrate 5 and also functions as an adhesive for bonding the circuit pattern 3 and the metal substrate 5 to each other. Accordingly, resin is generally used for the insulating layer 7. Although a thickness of the insulating layer 7 may be appropriately set, the thickness of the insulating layer is set to, for example, 0.13mm.

The insulating layer 7 of the present embodiment may be made of epoxy resin, cyanate resin, or the like. As the epoxy resin, for example, an amine-based curing agent, a phenol-based curing agent, an acid anhydride-based curing agent, or an imidazole-based curing agent are combined. For example, dicyandiamide or phenol resin is combined with the cyanate resin as a curing agent. Further, the insulating layer 7 may be made of liquid crystal polymer such as a wholly aromatic polyester which is thermoplastic resin, or other thermoplastic resin.

The insulating layer 7 preferably further contains inorganic fillers. As the inorganic fillers contained in the insulating layer 7, those having superior electrical insulating properties and high thermal conductivity are preferable. For example, as the inorganic fillers, alumina, silica, aluminum nitride, boron nitride, silicon nitride, magnesium oxide, and the like may be mentioned, and one or two or more selected from those may be preferably used.

A filling rate of the inorganic fillers in the insulating layer 7 may be appropriately set according to a type of the inorganic fillers. For example, it is preferably 85% by volume or less on the basis of a total volume of the resin contained in the insulating layer 7, and more preferably 30% to 85% by volume.

The insulating layer 7 may further contain, for example, a coupling agent, a dispersant, or the like. In addition, an insulating sheet in a semi-cured state may be used as the insulating layer 7.

The circuit pattern 3 is provided on the insulating layer 7. As a result, the circuit pattern 3 is provided on the insulating substrate being provided with the insulating layer 7 on the metal substrate 5. The circuit pattern 3 is a plate-shaped body or a foil, and is formed in a predetermined pattern by etching of a conductor 3a.

The circuit pattern 3 of the present embodiment is formed of a copper material which is a conductor for a circuit having a thickness of 0.3mm to 0.8mm, for example, 0.5mm. The circuit pattern 3 is constant in thickness except for a stacked portion of the additional metal layer 9. The thickness of the circuit pattern 3, however, may be varied.

The circuit pattern 3 may be formed of aluminum or the like. In addition, the circuit pattern 3 may be one formed in advance by pressing or cutting without etching and stuck on the metal substrate 5 through the insulating layer 7.

The other member 11 is connected to the circuit pattern 3 of the present embodiment. In a portion where the other member 11 is connected, the additional metal layer 9 is stacked and bonded so that the circuit pattern 3 is configured to be partially thick.

The additional metal layer 9 is formed in a plate shape. Although the additional metal layer 9 of the present embodiment is made of copper, it may be made of another conductor for a circuit such as aluminum. A planar shape of the additional metal layer 9 is, for example, a square of 10mm square. The planar shape of the additional metal layer 9, however, may be arbitrarily set.

A thickness of the additional metal layer 9 in the stacking direction is 0.4mm to 2.7mm. The thickness of the additional metal layer 9 in the stacking direction is larger than the thickness of the circuit pattern 3 in the stacking direction. The additional metal layer 9 has the constant thickness. A total thickness of the circuit pattern 3 and the additional metal layer 9 is 1.2mm to 3.0mm.

The additional metal layer 9 has a bonding surface 10 with respect to the circuit pattern 3 on one side in the stacking direction, and has a connecting surface 12 with respect to the other member 11 on the other side.

The bonding surface 10 includes a bonded portion 10a bonded to the circuit pattern 3 in a range facing the circuit pattern 3 in the stacking direction, and an un-bonded portion 10b that is a portion other than the bonded portion 10a. The bonded portion 10a is a portion in the bonding surface 10 in which the additional metal layer 9 is bonded to the circuit pattern 3 by ultrasonic bonding or the like as explained later. In the present embodiment, the bonded portion 10a is formed in a circumferential shape along an outer peripheral edge portion of the bonding surface 10, and has a predetermined width. It should be noted that the bonded portion 10a should be partially provided relative to the bonding surface 10 and does not need to be circumferential. A non-circumferential bonded portion is, for example, a C-shape in which part of a circumferential shape is open, one or a plurality of linear shapes, or the like.

The un-bonded portion 10b is a portion that is not bonded to the circuit pattern 3 in the bonding surface 10. The un-bonded portion 10b of the present embodiment is located inside the circumferential shape of the bonded portion 10a. In addition, the un-bonded portion 10b may be configured to be located inside and outside the bonded portion 10a. The un-bonded portion 10b is a rectangular region defined by the bonded portion 10a. It should be noted that, although the un-bonded portion 10b is illustrated as an angular shape in FIG. 3(B), the un-bonded portion is actually a roundish shape. The un-bonded portion 10b is formed by a flat surface. The planar shape of the un-bonded portion 10b is appropriately set in relation to the bonded portion 10a. A proportion of the un-bonded portion 10b is preferably set to about 20% to 90%, preferably about 30% to 50% of the bonding surface 10.

The connecting surface 12 includes a connection portion 13 and an uneven portion 17.

The connection portion 13 is a portion in the connecting surface 12 on which the other member 11 is mounted. The mounting may be performed by various joining methods. It is preferable that the un-bonded portion 10b of the bonding surface 10 overlaps a part or whole of the connection portion 13 in the stacking direction. In the present embodiment, substantially the whole of the connection portion 13 as part thereof overlaps the un-bonded portion 10b of the bonding surface 10 in the stacking direction. The un-bonded portion 10b is slightly narrower than the connection portion 13 in a planar shape. The planar shape of the un-bonded portion 10b may be the same as the planar shape of the connection portion 13 or larger than the planar shape of the connection portion 13.

The connection portion 13 of the present embodiment is formed of a surface having less unevenness than the uneven portion 17, and a flat surface in the present embodiment. The connection portion 13 may partially have a recess or the like. Although the planar shape of the connection portion 13 is square, it is not limited thereto.

The uneven portion 17 is provided at least in a portion of the connecting surface 12 corresponding to the bonded portion 10a of the bonding surface 10 of the additional metal layer 9 in the stacking direction. The uneven portion 17 of the present embodiment is formed in a circumferential shape along an outer peripheral edge portion of the connecting surface 12 corresponding to the bonded portion 10a of the bonding surface 10, and has a predetermined width.

Accordingly, the uneven portion 17 is provided adjacent to the connection portion 13. It should be noted that the adjacency of the uneven portion 17 to the connection portion 13 may be any of a position in contact with an outer edge of the connection portion 13 and an outer position having an interval with respect to the outer edge of the connection portion 13.

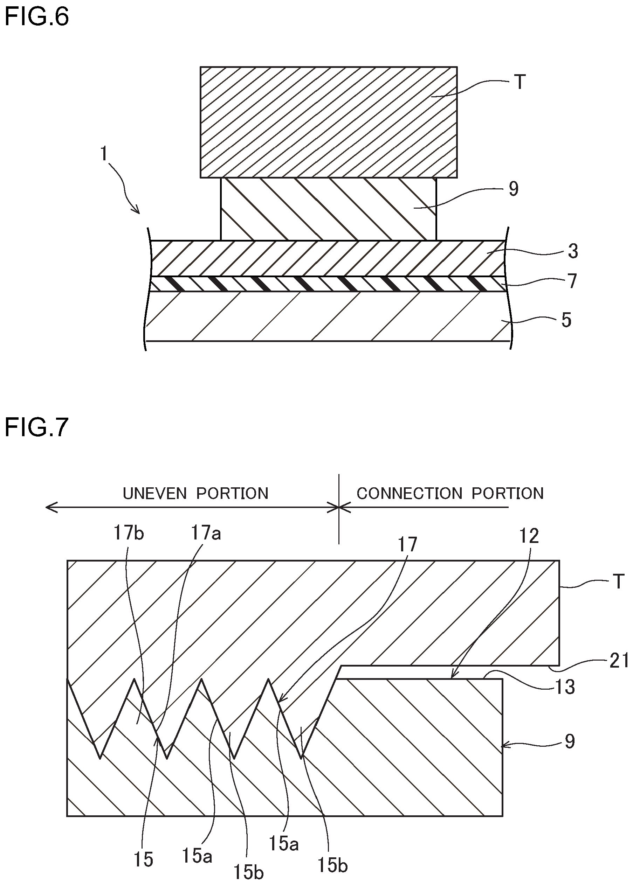

This uneven portion 17 is formed by means of a tool uneven portion 15 (to be explained later with reference to FIG. 7) of a tool T (to be explained later with reference to FIG. 7) for vibration transmission to ultrasonically bond the additional metal layer 9 on the circuit pattern 3 in the planar direction.

Although the uneven portion 17 may have various planar shapes and sectional shapes, the uneven portion is provided with engagement recesses 17a and engagement projections 17b in any case. The engagement recesses 17a and the engagement projections 17b of the present embodiment are intermittently provided on the whole circumference surrounding the connection portion 13.

The intermittence of the engagement recesses 17a and the engagement projections 17b on the whole circumference of the connection portion 13 means that the engagement recesses 17a and the engagement projections 17b are regularly arranged at regular intervals along each side of the connection portion 13 having the square shape. The intervals and sizes of the engagement recesses 17a and the engagement projections 17b may also be set at random.

The engagement recesses 17a and the engagement projections 17b are arranged in two or three rows between each side of the outer edge of the square of the additional metal layer 9 and the connection portion 13. The number of the rows is not particularly limited, and the number may be increased or decreased. The number of the rows may be made different on the respective sides of the square.

Each engagement recess 17a of the uneven portion 17 is formed in a quadrangular shape in a plan view and in an inverted square pyramid shape in a cross section. A bottom portion of the engagement recess 17a is lower than the connection portion 13 of the connecting surface 12. The uneven portion 17 is not particularly limited, and may be a recess or the like formed by a curved surface in shape of the engagement recess 17a.

Each engagement projection 17b has a square pyramid shape, a top portion of which is located at the same level as the connection portion 13 in the stacking direction. The uneven portion 17 including the engagement recesses 17a and the engagement projections 17b is an indentation of the tool uneven portion 15 to be explained later, and may have an appropriate shape depending on the shape of the tool uneven portion 15.

The other member 11 is an electronic component such as a semiconductor chip or a semiconductor device, a connection member to connect an electronic component, and the like. The other member 11 is connected to the connection portion 13 of the connecting surface 12 in the stacking direction. The other member 11 of the present embodiment is, for example, a rectangular plate-shaped member. The other member 11 has a gap between the other member and the uneven portion 17 in the intersecting direction. A thickness of the other member 11 in the stacking direction is 0.2mm to 1.2mm. In addition, the shape of the other member 11 may be arbitrarily set according to functions, characteristics, applications, and the like.

As mentioned above, in the circuit board 1, the additional metal layer 9 is partially bonded to the circuit pattern 3, to form the un-bonded portion 10b with respect to the circuit pattern 3 on the bonding surface 10. The additional metal layer 9, therefore, reduces heat resistance, and transfer of the heat from the additional metal layer 9 to the circuit pattern 3 is suppressed by the un-bonded portion 10b.

In the present embodiment, the heat input from the connection portion 13 to the additional metal layer 9 is, therefore, hard to be transmitted to the insulating layer 7 when the other member 11 is used, connected, or the like. It is possible to suppress damage to the insulating layer 7 by making it difficult for heat to be transferred thereto even when the heat input to the additional metal layer 9 increases.

In addition, since the total thickness of the additional metal layer 9 and the circuit pattern 3 in the stacking direction is 1.2mm to 3.0mm, the present embodiment more surely suppresses damage to the insulating layer 7.

In addition, the un-bonded portion 10b of the bonding surface 10 overlaps, in the stacking direction, the part or whole of the connection portion 13 of the connecting surface 12 to which the other member 11 is connected. Thus, it is hard to transmit the heat, input from the connection portion 13 to the additional metal layer 9 in the stacking direction, to the insulating layer 7 when the other member 11 is used, connected, or the like. The present embodiment, therefore, more surely suppresses damage to the insulating layer 7.

### [Experimental Results]

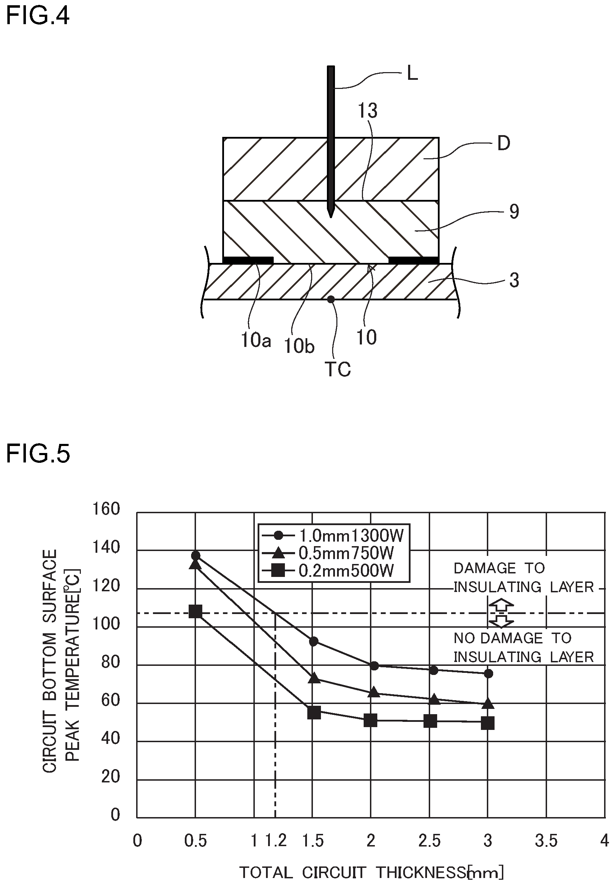

FIG. 4 is a sectional view illustrating an experimental method according to the embodiment 1. As illustrated in FIG. 4, in the experiment, the additional metal layer 9 is bonded to a surface of the circuit pattern 3 so as to have the above-mentioned un-bonded portion 10b. Then, locally heating is performed by irradiation with a laser beam L to a dummy D laminated on the connection portion 13 so as to simulate heat input from the connection portion 13 of the additional metal layer 9.

At this time, a temperature of a bottom surface of the circuit pattern 3 is measured at a portion TC corresponding to a laser-irradiated portion. The bottom surface of the circuit pattern 3 is a surface located on a side opposite in the stacking direction to the surface on which the laser irradiation of the dummy D is performed.

Material of the dummies D is copper, and the dummies D are set to 0.2mm, 0.5mm, and 1.0mm as general thicknesses for another member connected to the additional metal layer 9. Material of the circuit pattern 3 and the additional metal layer 9 is copper. The total thickness of the circuit pattern 3 and the additional metal layer 9 is 0.5mm to 3.0mm. In addition, intensity of a laser is changed to 500W, 750W, and 1300W according to the thicknesses of the dummies D, to have the setting to melt the additional metal layer 9 by 0.2mm ± 0.1mm.

FIG. 5 is a graph plotting experimental results of FIG. 4. An ordinate is a peak temperature (circuit bottom surface peak temperature) of the bottom surface of the circuit pattern 3, and an abscissa is the total thickness (total circuit thickness) of the circuit pattern 3 and the additional metal layer 9. In FIG. 5, 0.2mm500W indicates that the thickness of the dummy D is 0.2mm and the intensity of the laser is 500W. The same holds for 0.5mm750W and 1.0mm1300W.

As illustrated in FIG. 5, it is found that the circuit bottom surface peak temperature decreases as the total circuit thickness increases even in any thickness (laser intensity) of dummy D. If the intensity of the laser is the highest, the circuit bottom surface peak temperature becomes about 105 causing damage to the insulating layer 7 of the present embodiment when the total circuit thickness exceeds 1.2 mm. The lower limit of the total circuit thickness is, therefore, preferably set to 1.2 mm. If the total circuit thickness is 1.2 mm or more, the circuit bottom surface peak temperature is in a range that does not damage the insulating layer 7 up to 3.0 mm being the upper limit of the total thickness. In addition, if the total thickness exceeds 3.0mm, it causes increase in size so that the ultrasonic bonding is difficult and the suppression of the bottom surface temperature tends to be saturated, and it causes a problem that influence of the material thermal resistance is increased or the like. The upper limit of the total thickness is, therefore, set to 3.0 mm.

The insulating layer 7 is made of liquid crystal polymer and contains boron nitride and alumina. Although there is a difference in degree according to heat-resistant temperature of the resin, the insulating layer 7 is more or less damaged when the circuit bottom surface peak temperature becomes about 100. Further, the additional metal layer 9 and the circuit pattern 3 are made of copper as explained above. The range of the total thickness is, however, not greatly varied depending on the materials used for the insulating layer 7 of the circuit board 1, the circuit pattern 3 and the additional metal layer 9.

### [Manufacturing Method for Circuit Board]

FIG. 6 is a schematic sectional view of a situation in which the additional metal layer 9 is ultrasonically bonded to the circuit pattern 3 according to the embodiment 1. FIG. 7 is an enlarged sectional view of a portion of the tool T of FIG. 6 pressed against the additional metal layer 9.

As illustrated in FIGS. 6 and 7, this manufacturing method uses the tool T. In addition, FIG. 6 illustrates an example in which the tool T with a 12mm square is used for the additional metal layer 9 with a 10 mm square, the tool larger than the additional metal layer. It may use a tool T smaller than the additional metal layer 9.

The tool T has, in a sectional shape, a retracted portion 21 and the tool uneven portion 15 corresponding to the connection portion 13 and the uneven portion 17.

The retracted portion 21 forms a gap with respect to the connection portion 13 when the tool T is pressed against the additional metal layer 9. The retracted portion 21, however, may be in contact with the connection portion 13. The retracted portion 21 should be retracted from the connection portion 13.

The retracting is in degree to which the flat connection portion 13 is left with the presence of the retracted portion 21 in a state that the pressing of the tool T to the surface of the additional metal layer 9 is completed. Namely, the retracting includes that the retracted portion 21 is in contact with the additional metal layer 9 or that the retracted portion has a gap with respect to the additional metal layer, in process of pressing the tool T against the surface of the additional metal layer 9.

In the tool uneven portion 15, tool recesses 15a and tool projections 15b are formed corresponding to the engagement projections 17b and the engagement recesses 17a of the uneven portion 17.

In the manufacturing method of the present embodiment using the tool T, the additional metal layer 9 is stacked on the circuit pattern 3. Then, the tool T is partially pressed against the connecting surface 12 of the additional metal layer 9 and is ultrasonically vibrated. With this, the additional metal layer 9 is bonded onto the circuit pattern 3 by transmission of the ultrasonic vibration. This bonding is performed on part of the bonding surface 10 corresponding to, in the stacking direction, the portion of the connecting surface 12 of the additional metal layer 9 to which the tool T is pressed.

According to the present embodiment, the partially pressing of the tool T is performed by the retracted portion 21 of the tool T being retracted with respect to the connecting surface 12 while the tool uneven portion 15 of the tool T is pressed against the connecting surface 12. As a result, the connection portion 13 is formed in a range corresponding to the retracted portion 21, and the uneven portion 17 is formed in the range corresponding to the tool uneven portion 15.

After the additional metal layer 9 is bonded on the circuit pattern 3 in this way, the other member 11 is connected to the connecting surface 12 of the additional metal layer 9 as illustrated in FIGS. 1 and 2. In this connection, the other member 11 is positioned so as to be stacked on the connecting surface 12 of the additional metal layer 9. In this state, the other member 11 is connected to the connection portion 13 of the additional metal layer 9 by an appropriate method.

At this time, although heat may be generated, damage to the insulating layer 7 is suppressed as explained above.

### EMBODIMENT 2

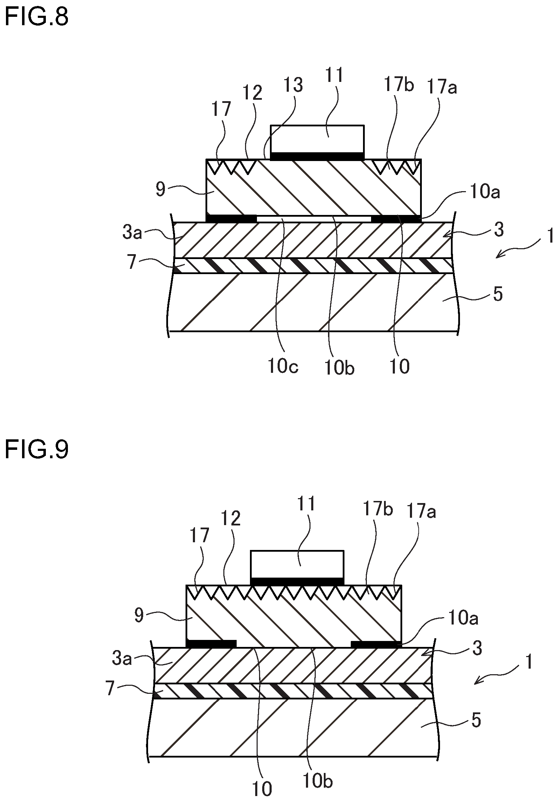

FIG. 8 is a sectional view of a circuit board illustrating an attaching portion of another member and a periphery thereof according to the embodiment 2 of the present invention. In addition, the embodiment 2 is in common with the embodiment 1 in the basic structure, and components corresponding to those in the embodiment 1 are represented with the same reference numerals as those in the embodiment 1, to omit redundant description.

As illustrated in FIG. 8, a circuit board 1 of the present embodiment is formed such that, in an additional metal layer 9, a thickness in the stacking direction at an un-bonded portion 10b of a bonding surface 10 is smaller than a thickness in the stacking direction at a bonded portion 10a of the bonding surface 10.

Namely, the additional metal layer 9 of the present embodiment has a recess 10c in the thickness direction at a portion corresponding to the un-bonded portion 10b of the bonding surface 10. The un-bonded portion 10b is formed by the recess 10c. The others are the same as those in the embodiment 1.

Accordingly, in the embodiment 2, heat input from the connection portion 13 to the additional metal layer 9 during use, connection or the like of the other member 11 is harder to be transmitted to the insulating layer 7, to more surely suppress damage to the insulating layer 7. In addition, the embodiment 2 provides the same effects as those of the embodiment 1.

### EMBODIMENT 3

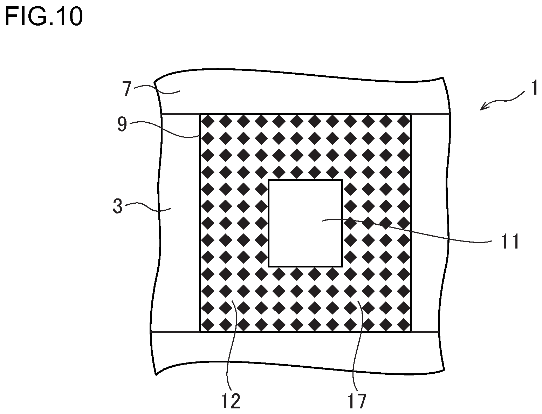

FIG. 9 is a sectional view of a circuit board illustrating an attaching portion of another member and a periphery thereof according to the embodiment 3 of the present invention. FIG. 10 is a plan view of the circuit board of FIG. 9. In addition, the embodiment 3 is in common with the embodiment 1 in the basic structure, and components corresponding to those in the embodiment 1 are represented with the same reference numerals as those in the embodiment 1, to omit redundant description.

In a circuit board 1 of the present embodiment, an uneven portion 17 is provided in a whole area of a connecting surface 12 of an additional metal layer 9.

When the additional metal layer 9 is bonded onto the circuit pattern 3, a tool T having a tool uneven portion 15 on a whole surface thereof is used. The tool T is ultrasonically vibrated while being pressed against the connecting surface 12 of the additional metal layer 9. Thus, the additional metal layer 9 is ultrasonically bonded onto the circuit pattern 3.

At this time, in the present embodiment, a bonding surface 10 of the additional metal layer 9 is partially bonded to the circuit pattern 3 according to setting of ultrasonic bonding condition to form a bonded portion 10a, and the remaining portion of the bonding surface 10 becomes an un-bonded portion 10b. The others are the same as those in the embodiment 1.

The embodiment 3 also provides the same effects as those of the embodiment 1. In addition, if the embodiment 3 is applied to an aspect with the recess 10c like the embodiment 2, there is no need to set the ultrasonic bonding condition to form the un-bonded portion 10b.

### DESCRIPTION OF NUMERALS

- 1: Circuit Board
- 3: Circuit Pattern
- 7: Insulating Layer
- 9: Additional Metal Layer
- 10: Bonding Surface
- 10a: Bonded Portion
- 10b: Un-bonded Portion
- 11: Other Member
- 12: Connecting Surface
- 13: Connection Portion
- 15: Tool Uneven Portion
- 17: Uneven Portion

## Claims

1. A circuit board comprising:
a circuit pattern provided on an insulating layer; and
an additional metal layer stacked and bonded on the circuit pattern for connecting another member, wherein
the additional metal layer comprises:
a bonding surface with respect to the circuit pattern; and
a connecting surface located on an opposite side to the bonding surface in a stacking direction for connecting the other member, wherein
the bonding surface includes a bonded portion bonded to the circuit pattern in a range facing the circuit pattern in the stacking direction and an un-bonded portion other than the bonded portion, and
a total thickness of the additional metal layer and the circuit pattern in the stacking direction is 1.2 mm to 3.0 mm.

2. The circuit board according to claim 1, wherein
the un-bonded portion of the bonding surface overlaps a part or whole of a connection portion of the connecting surface to which the other member is bonded in the stacking direction.

3. The circuit board according to claim 1, wherein
a thickness of the additional metal layer in the stacking direction is 0.4 mm to 2.7 mm, and
a thickness of the circuit pattern in the stacking direction is 0.3 mm to 0.8 mm.

4. The circuit board according to any one of claims 1 to 3, wherein
the additional metal layer has a thickness at the un-bonded portion of the bonding surface in the stacking direction smaller than a thickness at the bonded portion of the bonding surface in the stacking direction.

5. The circuit board according to any one of claims 1 to 3, wherein
the bonded portion of the bonding surface is formed in a circumferential shape, and the un-bonded portion of the bonding surface is located inside the circumferential shape of the bonded portion.

6. The circuit board according to any one of claims 1 to 3, wherein
the bonded portion of the bonding surface has an un-circular shape.

7. The circuit board according to any one of claims 1 to 3, wherein
at least an uneven portion is provided in a portion of the connecting surface corresponding to the bonded portion of the additional metal layer in the stacking direction.

8. The circuit board according to claim 7, wherein
the uneven portion is provided in a whole area of the connecting surface of the additional metal layer.

9. The circuit board according to claim 1 or 2, wherein
the other member is connected to the connecting surface of the additional metal layer in the stacking direction, and
the other member is a conductive plate material having a thickness of 0.2 mm to 1.2 mm in the stacking direction.

10. A manufacturing method for the circuit board according to any one of claims 1 to 3, wherein
stacking the additional metal layer on the circuit pattern; and
pressing a tool partially against the connecting surface of the additional metal layer and ultrasonically vibrating the tool, to bond part of the bonding surface onto the circuit pattern, the part corresponding to, in the stacking direction, a portion on the connecting surface of the additional metal layer pressed with the tool .

11. The manufacturing method for the circuit board according to claim 10, wherein
the other member is connected using laser welding to the connecting surface of the additional metal layer bonded on the circuit pattern.

12. A manufacturing method for the circuit board according to any one of claims 1 to 3, wherein
stacking the additional metal layer on the circuit pattern; and
pressing a tool wholly against the connecting surface of the additional metal layer and ultrasonically vibrating the tool, to bond part of the bonding surface onto the circuit pattern within a range of the bonding surface corresponding to, in the stacking direction, a portion on the connecting surface of the additional metal layer pressed with the tool.
